# EUROPEAN PATENT SPECIFICATION

(11) **EP 2 473 017 B1**
(45) Date of publication and mention of the grant of the patent: **25.12.2013**
(21) Application number: 12160665.1
(22) Date of filing: 03.03.2009
(51) Int. Cl.: H05K 7/12, H05K 7/20, H05K 5/02

(54) **Mounting component and assembly of mounting component**
Montagebauteil und Anordnung des Montagebauteils
Élément de montage et ensemble d'éléments de montage

(30) Priority: 25.07.2008 CN 200810144512
(43) Date of publication of application: 04.07.2012
(62) Divisional of application: 09799943.7
(73) Proprietor: Huawei Technologies Co., Ltd., Guangdong 518129 (CN)
(72) Inventor: Liu, Changlin, Shenzhen (CN); Deng, Shunqing, Shenzhen (CN); Liu, Zhongxin, Shenzhen (CN)
(74) Representative: Kreuz, Georg Maria

(56) References cited:
- WO-A1-2004/105261
- WO-A1-2007/124630
- CN-Y- 2 674 802
- GB-A- 2 445 153
- JP-A- 2005 286 086
- NL-A- 7 712 650
- US-A- 4 211 381

## Description

### FIELD OF THE TECHNOLOGY

The present invention relates to the field of communication technology, and more particularly to a mounting component, and an assembly of a mounting component.

### BACKGROUND OF THE INVENTION

In the prior art, in order to meet the demands of different mounting/erecting configurations and scenarios in sites, a Radio Remote Unit (RRU) is required to be mounted to have a flexibly assembled structure which can be mounted and maintained separately. In addition, the mounting of the RRU requires the consistent arrangement of a mounting component and accessories thereof, so as to decrease the operability of each stage throughout the whole process, reduce the waste of the materials, and thus save the cost throughout the whole process.

In the prior art, a mounting structure adapted to mount an RRU is typically an assembly mounting of a machine frame and a mounting backplate, in which the mounting backplate is fixed on a mounting place (for example, a wall), the machine frame is mounted on the mounting place, and an RRU is inserted in the fixed machine frame and tightened, and finally a plastic shell against solar radiation is covered thereon. The steps for mounting the RRU in the prior art are as follows.

In Step 1, a mounting backplate is fixed on a wall with expansion bolts.

In Step 2, a machine frame is placed on the mounting backplate and fixed thereto.

In Step 3, an RRU is inserted in the fixed machine frame.

In Step 4, the mounting of the RRU is completed.

In Step 5, a plastic shell is mounted.

In Step 6, the plastic shell is fixed.

The prior art has at least the following disadvantages:
As the RRU is mounted using the assembly mounting of the machine frame and the mounting backplate, the mounting steps of the RRU are complicated and have low flexibility.

WO 2004/105261 discloses a housing apparatus of an out-door communication device for receiving electronic parts for communication and thermal-emission devices. The housing apparatus for an outdoor communication device includes a housing that receives electronic parts for communication and thermal-emission device therein. The housing is coupled to an external column by a plurality of mounting brackets and screws.

### SUMMARY OF THE INVENTION

The present invention is directed to a mounting component for mounting communications equipment, more specially, an assembly of a mounting component, so as to simplify the mounting process.

A mounting component for mounting communications equipment is provided, which includes a buckling member and a steel strip, wherein the buckling member and the steel strip are cooperatively fixed on a fixture; the buckling member has a main fastener having a rear side, a front side, a left side, and a right side, wherein a clamp portion is formed at the front side of the main fastener; the main fastener further comprises a dovetail which is disposed at the rear side of the main fastener for interlocking a retaining member of the communications equipment; wherein a first buckling portion is disposed at the left side of the main fastener and is interlocked with a second buckling portion at a right side of another main fastener; and/or, a second buckling portion is disposed at the right side of the main fastener and is interlocked with a first buckling portion at a left side of another main fastener.

A main fastener is provided, which includes a front side, a rear side, a left side, and a right side, wherein a clamp portion is formed at the front side of the main fastener, the main fastener further comprises a dovetail for interlocking a retaining member of a communications equipment which is disposed at the rear side of the main fastener; wherein a first buckling portion is positioned at the left side of the main fastener and is interlocked with a second buckling portion at a right side of another main fastener; and/or a second buckling portion is positioned at the right side of the main fastener and is interlocked with a first buckling portion at a left side of another main fastener.

It can be seen from the technical solutions that, the connecting portion of the buckling member is interlocked with the retaining member of the communications equipment, such that the communications equipment is attached to the buckling member. This mounting process is easier and more flexible.

### BRIEF DESCRIPTION OF THE DRAWINGS

To illustrate the technical solutions according to the embodiments of the present invention or in the prior art more clearly, the accompanying drawings for describing the embodiments or the prior art are introduced briefly as follows. Obviously, the accompanying drawings in the following description are only some embodiments of the present invention.
FIG. 1 is a schematic structural view of a mounting component according to an embodiment of the present invention;
FIG. 2 is a schematic structural view of a main fastener according to a first embodiment of the present invention;
FIG. 3 is a schematic structural view of a main fastener according to the first embodiment of the present invention;
FIG. 4 is a schematic structural view of a main fastener according to the first embodiment of the present invention;
FIG. 5 is a schematic structural view of a main fastener having a screw with waisted shank according to the first embodiment of the present invention;
FIG. 6 is a schematic structural view of a screw with waisted shank according to an embodiment of the present invention;
FIG. 7 is a cross-sectional view of a waisted shank structure according to the first embodiment of the present invention;
FIG. 8 is a schematic structural view of a mounting component according to a second embodiment of the present invention;
FIG. 9 is a schematic structural view of a retaining member of an RRU according to an embodiment of the present invention;
FIG. 10 is a schematic view of mounting a mounting component according to an embodiment of the present invention;
FIG. 11 is a schematic view of mounting a mounting component according to an embodiment of the present invention;
FIG. 12 is a schematic view of mounting an RRU according to an embodiment of the present invention;
FIG. 13 is a diagram showing a mounting result of an RRU according to an embodiment of the present invention;
FIG. 14 is a schematic view of connecting a plurality of main fasteners according to an embodiment of the present invention;
FIG. 15 is a schematic view of connecting a plurality of main fasteners according to an embodiment of the present invention;
FIG. 16 is a schematic view of mounting RRUs at a single side of a plurality of main fasteners according to an embodiment of the present invention;
FIG. 17 is a schematic view of centralized mounting effect of RRUs at a single side according to an embodiment of the present invention; and
FIG. 18 is a schematic view of centralized mounting effect of RRUs at both sides according to an embodiment of the present invention.

### DETAILED DESCRIPTION OF THE EMBODIMENTS

The technical solution of the present invention will be clearly and completely described as follows accompanying with the drawings. It is obvious that the embodiments to be described are only a part rather than all of the embodiments of the present invention.

In an embodiment, the present invention provides a mounting component for mounting communications equipment, which includes a buckling member and an auxiliary member. The buckling member and the auxiliary member are cooperatively fixed on a fixture. The buckling member has a connecting portion for interlocking a retaining member of the communications equipment.

It can be seen from the above that, the mounting component according to the embodiment of the present invention is interlocked with the retaining member of the communications equipment through the connecting portion of the buckling member, such that the communications equipment is attached to the buckling member. This mounting process is easier and more flexible.

The connecting portion may be a dovetail.

The communications equipment may be an RRU.

The fixture may be a holding pole or an angle steel.

Hereinafter, descriptions are made with the connecting portion as a dovetail.

### First Embodiment

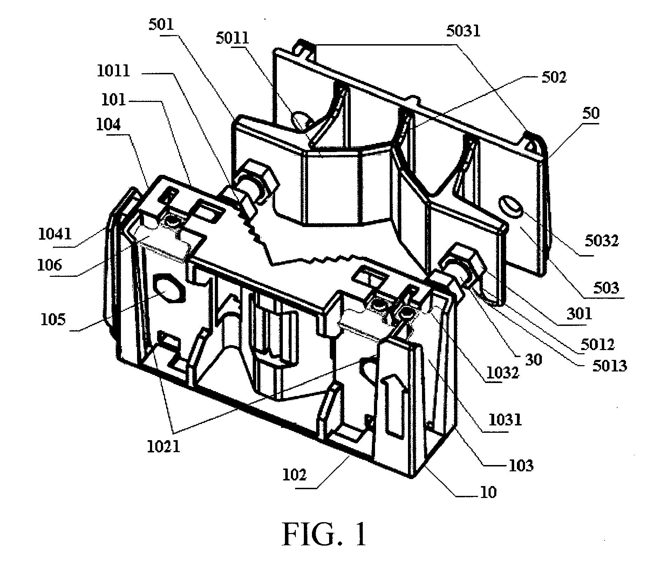

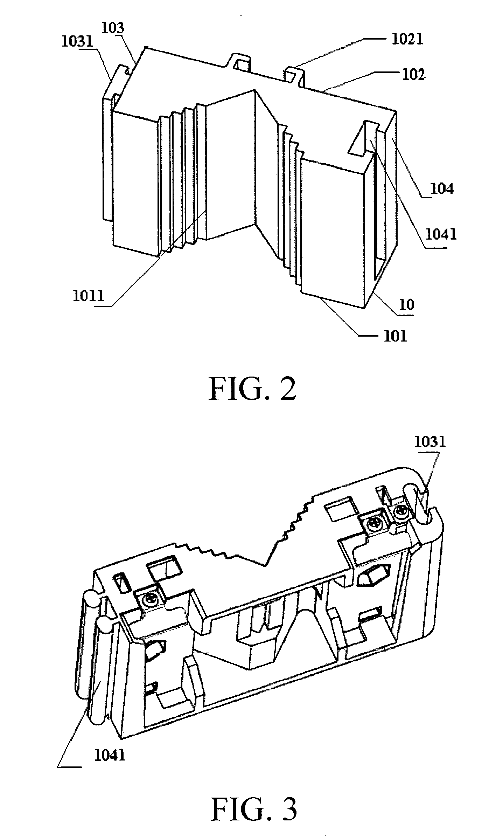

FIGs. 1 and 2 are schematic structural views of a mounting component for mounting communications equipment according to an embodiment of the present invention. Referring to FIGs. 1 and 2, a buckling member includes a main fastener 10 and long protruding portions 30. The main fastener 10 has four sides, that is, a front side 101, a rear side 102, a left side 103, and a right side 104.

A clamp portion 1011 of the main fastener is formed at the front side 101 of the main fastener, and a dovetail 1021 is disposed on a side opposite to the clamp portion 1011 of the main fastener, that is, disposed on the rear side 102 of the main fastener. A first buckling portion 1031 is disposed at the left side 103 of the main fastener, and a second buckling portion 1041 is disposed at the right side 104 of the main fastener. The first buckling portion 1031 is interlocked with a second buckling portion at a right side of another main fastener, and the second buckling portion 1041 is interlocked with a first buckling portion at a left side of another main fastener.

It can be seen from the above that, the main fastener of the mounting component according to the embodiment of the present invention is interlocked with the retaining member fixed on the communications equipment through the dovetail, such that the communication equipment communications equipment is attached to the main fastener. This mounting process is easier and more flexible.

It can be understood that structure of the other main fasteners may be the same as that of the main fastener 10, and the first buckling portion of the other main fasteners may be interlocked with the second buckling portion of the main fastener 10; or the second buckling portion of the other main fasteners may be interlocked with the first buckling portion of the main fastener 10. In this manner, the dovetail of the other main fasteners may be interlocked with the retaining member of another communications equipment, and thus the communications equipment is attached to the other main fasteners.

The dovetail 1021 disposed at the rear side 102 of the main fastener may be a female dovetail groove or a male dovetail.

The first buckling portion 1031 may be a male dovetail, and the second buckling portion 1041 may be a female dovetail groove. Alternatively, the first buckling portion 1031 may be a female dovetail groove, and the second buckling portion 1041 may be a male dovetail.

Further, a blade spring 1032 may be disposed at an upper edge of the buckling portion that is configured as a female dovetail groove, such that the blade spring 1032 is pressed against a step-like structure of a male dovetail of another main fastener, when the female dovetail groove of the buckling portion is interlocked with the male dovetail of the another main fastener.

The first buckling portion 1031 and the second buckling portion 1041 may alternatively be as shown in FIG. 3. In FIG. 3, the first buckling portion 1031 may be a cylindrical groove, and the second buckling portion 1041 may be a cylindrical protrusion. The structure of another main fastener is the same as that of the main fastener 10, as such, the cylindrical groove of the main fastener 10 may be interlocked with a cylindrical protrusion of the another main fastener, and the cylindrical protrusion of the main fastener 10 may be interlocked with a cylindrical groove of the another main fastener.

Further, long protruding portions 30 are disposed at the front side 101 of the main fastener and at both sides of the clamp portion 1011 of the main fastener.

Referring to FIG. 2 again, the dovetail 1021 disposed at the rear side 102 of the main fastener may be one, and located at nearly a central position of the rear side 102 of the main fastener. The dovetail may be a male dovetail or a female dovetail groove.

Alternatively, the dovetails 1021 disposed on the rear side 102 of the main fastener may be two, and respectively located at both sides of the rear side 102 of the main fastener.

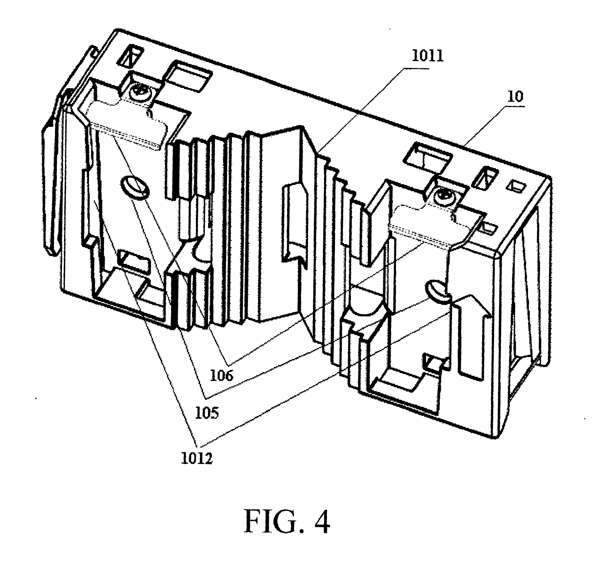

Referring to FIG. 4, furthermore, dovetails 1012 are disposed at the front side 101 of the main fastener and at both sides of the clamp portion 1011 of the main fastener. For facilitating the assembly of an RRUs, the sizes of the retaining members of the RRUs may be the same, the position of the dovetail at the front side 101 of the main fastener is required to be opposite to the position of the dovetail at the rear side 102 of the main fastener (not shown in FIG. 4). The dovetail at the front side 101 of the main fastener may be a female dovetail groove or a male dovetail.

Referring to FIGs. 1 and 4, the long protruding portions 30 may be long bolts, and holes 105 are opened extending through the front side 101 of the main fastener and the rear side 102 of the main fastener. The holes 105 may extend through the dovetail at the front side 101 of the main fastener and the dovetail at the rear side 102 of the main fastener. The long bolts pass through the holes 105, and are fixed on the main fastener 10.

Referring to FIG. 1 again, one end of the hole 105 is a hexagonal counterbore (not shown) having a diameter larger than that of the hole 105. A nut that mates with the hexagonal counter bore to prevent the long bolt from rotating is disposed at one end of the long bolt, thereby securing the long bolt to the main fastener 10.

In addition, referring to FIG. 4, if the dovetail at the front side or the rear side of the main fastener is a female dovetail groove, and a blade spring 106 is disposed on the upper edge of the female dovetail groove. When the female dovetail groove is interlocked with the male dovetail on the retaining member of the RRU, the blade spring 106 is pressed against a step-like structure of the male dovetail.

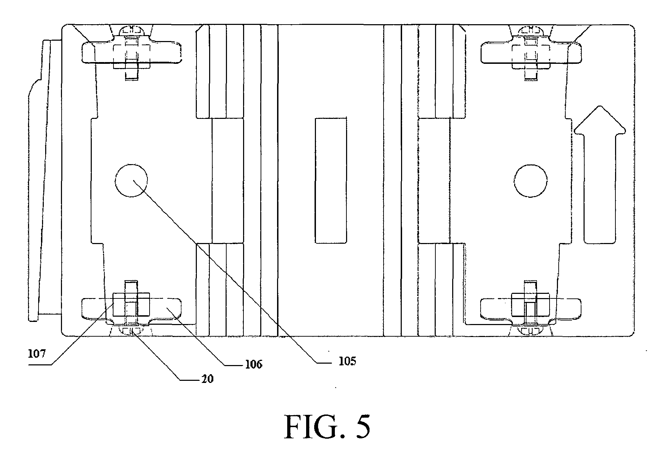

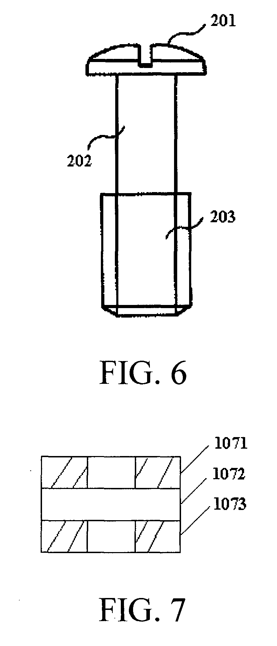

Referring to FIG. 5, for the disposition of the blade spring 106 on the female dovetail groove, the blade spring 106 may be attached to the upper edge of the female dovetail groove by using a waisted shank bolt 20. The structure of the waisted shank bolt is shown in FIG. 6, which includes a nut cap 201, a shank 202, and a threaded portion 203, and the diameter of the shank 202 is smaller than the inner diameter of the threaded portion 203. Correspondingly, a structure with waisted shank 107 is formed at an upper portion of the female dovetail groove of the main fastener. A cross-sectional view of the structure with waisted shank 107 is shown in FIG. 7, which includes a threaded portion 1071, an unthreaded portion 1072, and a lower threaded portion 1073, and the unthreaded portion 1072 may be a square hole.

Specifically, the waisted shank bolt 20, the structure with waisted shank 107, and the blade spring 106 of the main fastener is collected in the following way. The waisted shank bolt 20 passes through the blade spring, with the threaded portion 203 screwed in the lower threaded portion 1073 of the structure with waisted shank 107, such that the blade spring of the main fastener is in a tightened state. When an RRU needs to be fixed, the blade spring of the main fastener presses against a step-like structure of a male dovetail on a retaining member of the RRU. The waisted shank bolt 20 is screwed upward, the blade spring of the main fastener is drooped when the threaded portion 203 is screwed out from the lower threaded portion 1073 of the structure with waisted shank 107 to the unthreaded portion 1072, and then the RRU is taken out.

Referring to FIG. 1 again, an auxiliary member of the mounting component for mounting the communications equipment according to the embodiment of the present invention is an auxiliary fastener 50, which includes a front portion 501, a middle portion 502, and a rear portion 503. The front portion 501 is connected to the rear portion 503 through the middle portion 502. An auxiliary clamp portion 5011 is opened at nearly a central position of the front portion 501 of the auxiliary fastener 50, and notches 5012 are defined at the front portion of the auxiliary fastener located at both sides of the auxiliary clamp portion 5011 in which one end of the notches 5012 is unclosed.

In addition, a dovetail 5031 is disposed at the rear portion 503 of the auxiliary fastener 50 for interlocking the dovetail at the front side 101 of the main fastener.

Further, holes 5032 are defined in the rear portion 503 of the auxiliary fastener 50, and configured corresponding to the holes 105.

It can be understood that the dovetail 5031 at the rear portion 503 of the auxiliary fastener 50 may be a male dovetail, and correspondingly, the dovetail at the front side 101 of the main fastener may be a female dovetail groove; and the dovetail 5031 at the rear portion 503 of the auxiliary fastener 50 may be a female dovetail groove, and correspondingly, the dovetail at the front side 101 of the main fastener may be a male dovetail.

Referring to FIG. 1 again, the long protruding portions 30, the main fastener 10, and the auxiliary fastener 50 are assembled as follows.

One end of the long protruding portion 30 passes through the hole 105 of the main fastener 10 and is fixed on the main fastener 10, and the other end of the long protruding portion 30 is interlocked with the notch 5012 of the auxiliary fastener 50 and is fixed through a nut, as such the long protruding portion 30, the main fastener 10, and the auxiliary fastener 50 are assembled as a whole.

In order to ensure long protruding portion 30 to be well fixed in the notch 5012, a blade spring 5013 is arranged at an opening of the notch 5012 of the auxiliary fastener 50, and the blade spring is fixed on the auxiliary fastener 50 with a screw, such that the blade spring 5013 is pressed against the long protruding portion 30.

Further, the long protruding portion 30 is sleeved with a joint nut 301. The middle portion of the joint nut 301 of the long protruding portion 30 is an intermediate connecting portion of the joint nut 301 and received in notch 5012. The joint nut 301 is tightened to fix the main fastener 10 and the auxiliary fastener 50. The blade spring 5013 is pressed against the intermediate connecting portion of the joint nut sleeved on the long protruding portion.

In addition, the long protruding portion 30 may be a long bolt with a nut disposed at one end, and the nut mates with the hexagonal counter bore at one end of the hole 105, so as to fix the long bolt and the main fastener 10.

Further, the other end of the long protruding portion 30 passes through the hole 5032 of the auxiliary fastener, and is fixed by a fixing member such as a nut.

### Second Embodiment

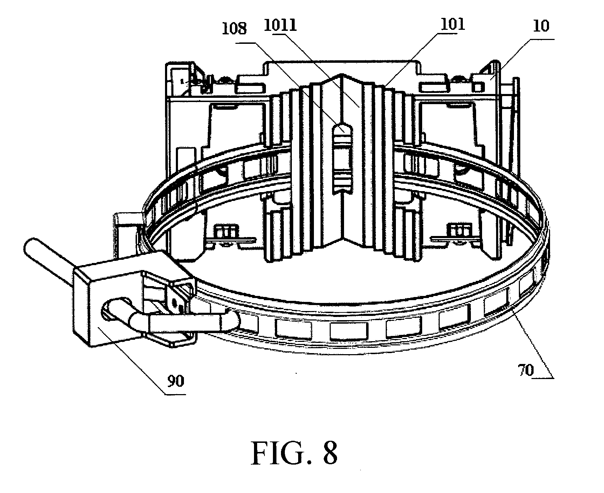

FIG. 8 is a schematic structural view of a mounting component according to an embodiment of the present invention. As shown in FIG. 8, an auxiliary member may be an auxiliary strip 70. The mounting component includes a buckling member and the auxiliary strip 70. The buckling member includes a main fastener.

The distinction between the main fastener of this embodiment and the main fastener 10 of the first embodiment is that, at a front side 101 of the main fastener, for example, in a clamp portion 1011 of the main fastener, a through hole 108 is defined, the width of the through hole matches with that of the auxiliary strip 70, so that the auxiliary strip 70 can pass through the through hole 108 and be fixed on the main fastener 10.

The auxiliary strip 70 may be a steel strip.

The main fastener and the auxiliary strip 70 are assembled as follows.

The auxiliary strip 70 passes through the through hole 108 and is fixed on the main fastener 10. The auxiliary strip 70 is fixed on a fixture through a locker 90.

The fixture may be a holding pole or an angle steel.

It should be noted that the main fastener in the second embodiment may have a structure similar to the main fastener 10 in the first embodiment, for example, a dovetail 1021 is formed at a rear side 102 of the main fastener, and is interlocked with a retaining member fixed on communications equipment. The structure of the main fastener will not be detailed herein again.

It can be seen from the above that, the main fastener of the mounting component according to the embodiment of the present invention is interlocked with the retaining member of the communications equipment through the dovetail, such that the communications equipment is attached to the main fastener. This mounting process is easier and more flexible.

The mounting component for mounting the communications equipment according to the embodiment of the present invention is described above, and the retaining member fixed on the communications equipment (that is, the retaining member of the communications equipment) is described in the following.

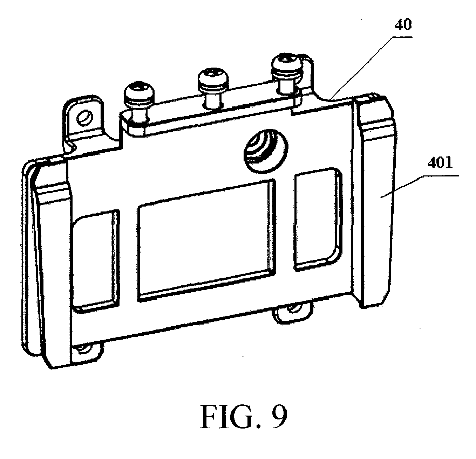

FIG. 9 is a schematic structural view of a retaining member 40 fixed on the communications equipment according to the embodiment of the present invention. A dovetail 401 is disposed at one side of the retaining member 40, and fixed on the communications equipment with a screw.

The communications equipment may be an RRU.

The dovetail 401 may be a female dovetail groove or a male dovetail.

Referring to FIG. 9 again, the retaining member is fixed on the communications equipment with a screw. Specifically, two holes are respectively defined in the retaining member 40 and the communications equipment, and a screw passes through the hole in the retaining member and the hole in the communications equipment to fix the retaining member 40 on the communications equipment.

### Third Embodiment

In this embodiment, the present invention provides an assembly of a mounting component, which further includes the communications equipment, a retaining member fixed on the communications equipment, a buckling member, and an auxiliary member. The buckling member is interlocked with the auxiliary member, and is fixed on a fixture. The buckling member has a connecting portion for interlocking the retaining member of the communications equipment.

It can be seen from the above that, as for the assembly of the mounting component according to the embodiment of the present invention, the communications equipment is attached to the buckling member easily by interlocking the connecting portion of the buckling member with the retaining member of the communications equipment. This mounting process is easier and more flexible.

Further, the buckling member includes a main fastener and long protruding portions. The auxiliary member is an auxiliary fastener. A front side of the main fastener and/or a front portion of the auxiliary fastener has a clamp portion for clasping the fixture, and the long protruding portions protrude from both sides of the front side of the main fastener and are retained in notches in the front portion of the auxiliary fastener. The structure of the mounting component is similar to that in the above embodiment, and the details may not be described herein again.

Further, the buckling member is a main fastener, and the auxiliary member is an auxiliary strip. A front side of the main fastener has a through hole, and the width of the through hole matches with that of the auxiliary strip so that the auxiliary strip can pass through the through hole and to be fixed on the main fastener. The structure of the mounting component is similar to that in the above embodiment, and the details may not be described herein again.

It should be noted that in the assembly of the mounting component according to the embodiment of the present invention, the structures of the buckling member, the auxiliary member, and the retaining member of the communications equipment are the same as those of the buckling member, the auxiliary member, and the retaining member of the communications equipment in the above embodiments, and no more details will be given again.

An example is given below for illustration, in which the communications equipment is an RRU, and the installation of one or a plurality of RRUs will be described respectively as follows.

### Mounting of one RRU

The RRU may be mounted by using the mounting component of the first embodiment in the following manner.

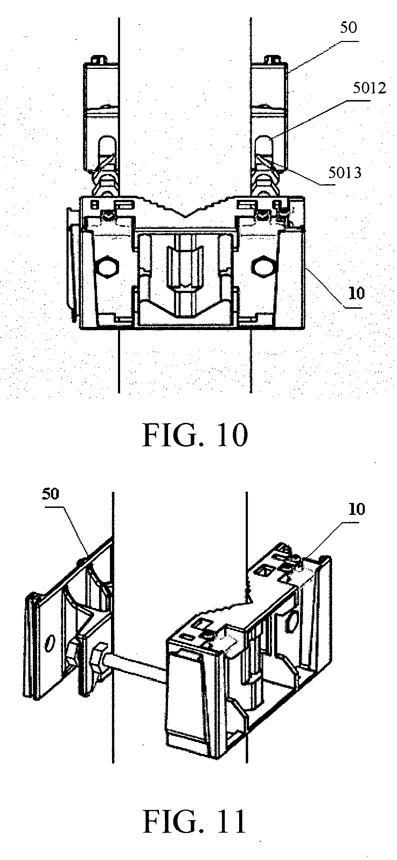

Referring to FIGs. 1, 10, and 11, the clamp portion 1011 of the main fastener is attached to a holding pole or an angle steel. Then, the notches 5012 of the auxiliary fastener 50 retains the intermediate connecting portions of the joint nuts 301 sleeved on the long bolts protruding from both sides of the clamp portion 1011 of the main fastener, such that the blade springs 5013 of the auxiliary fastener press against the intermediate connecting portions of the joint nuts 301. Next, the joint nuts 301 are tightened, to secure the main fastener 10 and the auxiliary fastener 50 on the holding pole or the angle steel. If the width of the holding pole or the angle steel is too small, the long bolts 30 pass through the notches 5012 and then through the holes 5032, so as to make the mounting component firmly attached to the holding pole or the angle steel.

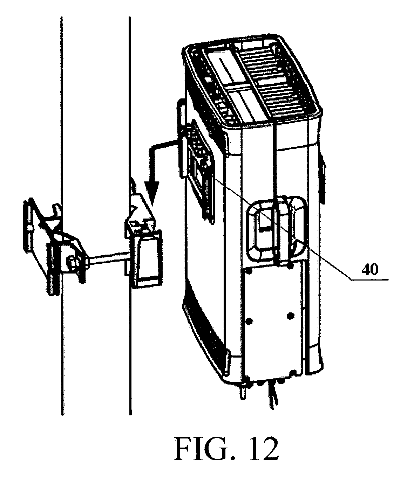

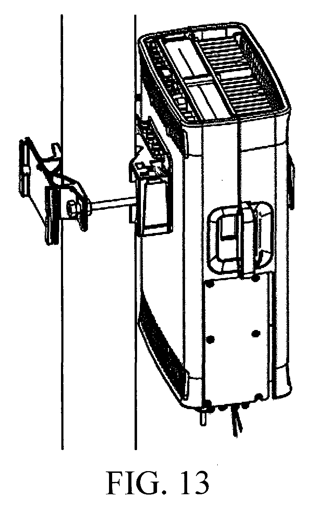

Referring to FIGs. 1, 9, 12, and 13, the dovetail 401 at the retaining member of the RRU is interlocked with the dovetail 1021 at the rear side 102 of the main fastener. If the dovetail 401 at the retaining member of the RRU is a male dovetail, and the dovetail 1021 at the rear side 102 of the main fastener is a female dovetail groove, the blade springs 106 of the main fastener at the upper edge of the female dovetail groove press against the step-like structure of the male dovetail on the retaining member, so as to prevent the retaining member of the RRU from falling off.

In the embodiment of the present invention, the long bolts protruding from the front side of the main fastener are retained in the notches in the front portion of the auxiliary fastener, to fix the main fastener and the auxiliary fastener on a fixture such as a holding pole or an angle steel. Then, the dovetail at the rear side of the main fastener is interlocked with the dovetail on the retaining member of the RRU, such that the RRU is fixed on the mounting component. The whole mounting process has fewer steps and is simple. Besides, the mounting component achieves the purpose of fixing the RRU only by using the main fastener and the auxiliary fastener, and thus the cost of the mounting component is lowered.

Referring to FIGs. 1, 8, and 9, the RRU may be mounted using the mounting component of the second embodiment in the following manner.

Firstly, the auxiliary strip 70 passes through the through hole 108 in the main fastener, and is fixed on the main fastener 10. Then, the auxiliary strip 70 is fixed on a holding pole or an angle steel through the locker 90.

Next, the dovetail 401 at the retaining member of the RRU is interlocked with the dovetail 1021 at the rear side 102 of the main fastener. If the dovetail 401 at the retaining member of the RRU is a male dovetail, and the dovetail 1021 at the rear side 102 of the main fastener is a female dovetail groove, the blade springs 106 of the main fastener at the upper edge of the female dovetail groove press against the step-like structure of the male dovetail on the retaining member, so as to prevent the retaining member of the RRU from falling off.

In the embodiment of the present invention, the main fastener and the auxiliary strip 70 are fixed in the through hole 108 of the main fastener, and then the auxiliary strip 70 is fixed on the holding pole or the angle steel. Then, the dovetail at the rear side of the main fastener is interlocked with the dovetail on the retaining member of the RRU, such that the RRU is fixed on the mounting component. The whole mounting process has fewer steps and is simple. Besides, the mounting component achieves the purpose of fixing the communications equipment only by using the main fastener and the auxiliary strip, and thus the cost of the mounting component is lowered.

### Mounting of a plurality of RRUs at a single side of a holding pole or an angle steel

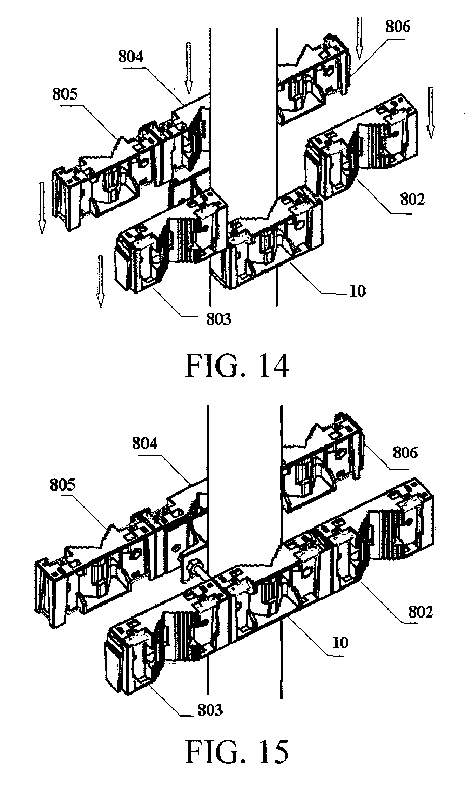

Referring to FIGs. 1, 14, and 15, the mounting manner of a single RRU is the same as the above, and in the case that a plurality of RRUs, for example, three RRUs, needs to be mounted at a single side of a holding pole or an angle steel, the main fastener having a clamp portion attached to the angle steel is a first main fastener 10, the structure of which is similar to that in the first embodiment, so the details may not be described herein again. A first buckling portion 1031 of the first main fastener 10 is interlocked with a second buckling portion of a second main fastener 802, and a second buckling portion 1041 of the first main fastener is interlocked with a first buckling portion of a third main fastener 803. A dovetail at a rear side of the first main fastener 10 is interlocked with a retaining member of the RRU, and dovetails at front sides of the second main fastener 802 and the third main fastener 803 are respectively interlocked with retaining members of the RRUs.

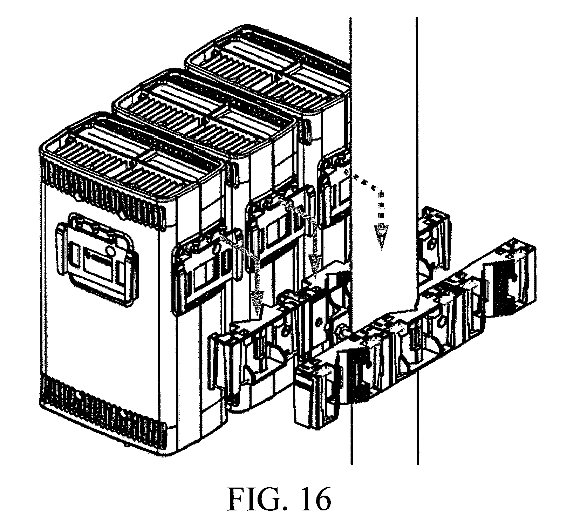

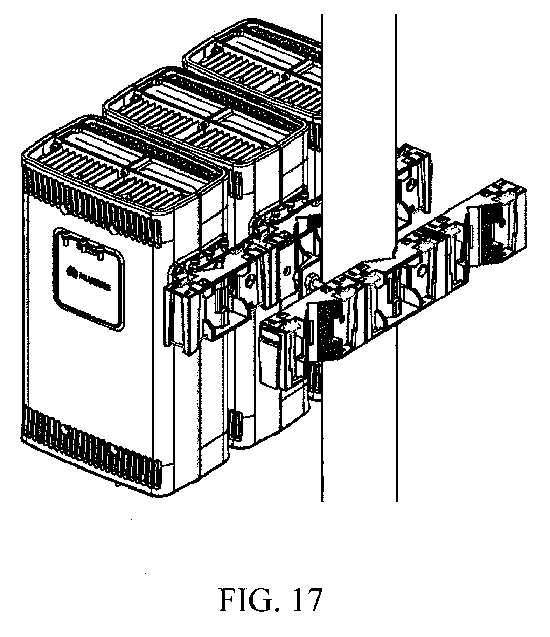

Definitely, the RRU may also be mounted by attaching the auxiliary fastener to the main fastener at one side. At one side of the auxiliary fastener 50, the auxiliary fastener 50 is fixed on a fourth main fastener 804 by interlocking the dovetail at the rear portion of the auxiliary fastener with a dovetail at a front side of the fourth main fastener 804. A first buckling portion of the fourth main fastener 804 is interlocked with a second buckling portion of a fifth main fastener 805, and a second buckling portion of the fourth main fastener 804 is interlocked with a first buckling portion of a sixth main fastener 806. A dovetail at a rear side of the fourth main fastener 804 is interlocked with the retaining member of the RRU, and dovetails at front sides of the fifth main fastener 805 and the sixth main fastener 806 are interlocked with the retaining members of the RRUs. The mounting step of the RRUs is shown in FIG. 16, and the mounting result is shown in FIG. 17.

### Mounting of a plurality of RRUs at opposite sides of a holding pole or an angle steel

Referring to FIGs. 1, 14, and 15, it is assumed that three RRUs are required to be respectively mounted at opposite sides of a holding pole or an angle steel, and in this case, the main fastener having a clamp portion attached to the angle steel is a first main fastener 10, the structure of which is similar to that in the first embodiment, so the details may not be described herein again. A first buckling portion 1031 of the first main fastener 10 is interlocked with a second buckling portion of a second main fastener 802, and a second buckling portion 1041 of the first main fastener is interlocked with a first buckling portion of a third main fastener 803. A dovetail at a rear side of the first main fastener 10 is interlocked with a retaining member of the RRU, and dovetails at front sides of the second main fastener 802 and the third main fastener 803 are interlocked with retaining members of the RRUs.

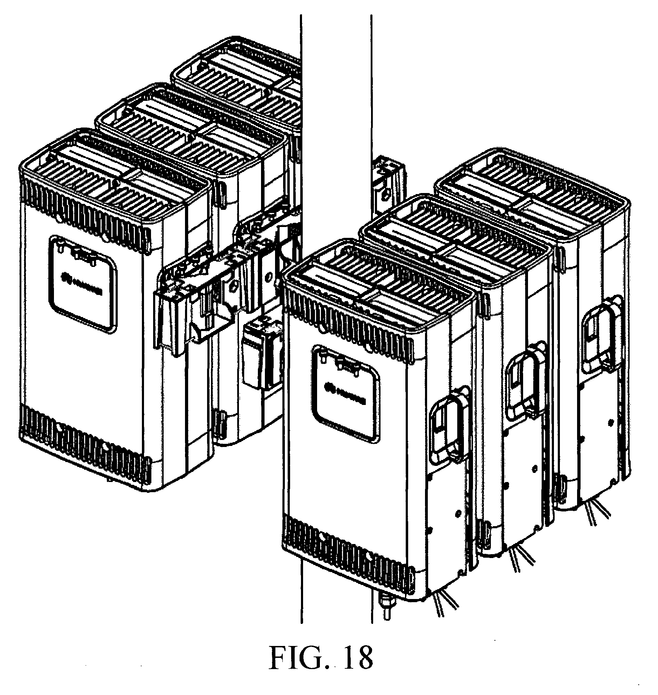

At one side of the auxiliary fastener 50, the auxiliary fastener 50 is fixed on a fourth main fastener 804 by interlocking the dovetail at the rear portion of the auxiliary fastener with a dovetail at a front side of the fourth main fastener 804. A first buckling portion of the fourth main fastener 804 is interlocked with a second buckling portion of a fifth main fastener 805, and a second buckling portion of the fourth main fastener 804 is interlocked with a first buckling portion of a sixth main fastener 806. A dovetail at a rear side of the fourth main fastener 804 is interlocked with the retaining member of the RRU, and dovetails at front sides of the fifth main fastener 805 and the sixth main fastener 806 are interlocked with the retaining members of the RRUs. The mounting result is shown in FIG. 18.

According to the embodiment of the present invention, the main fastener is interlocked with other main fasteners through the first buckling portion and/or the second buckling portion, and then the RRUs are mounted on the other main fasteners, so as to achieve the centralized mounting of the RRUs, and the mounting process of the RRUs is simple and practical.

The mounting component, the main fastener, and the assembly of the mounting component according to the embodiments of the present invention are described in detail above. The principle and implementation of the present invention are described herein through specific examples. The description about the embodiments of the present invention is merely provided for ease of understanding of the method and core ideas of the present invention. Therefore, the specification shall not be construed as a limit to the present invention.

## Claims

1. A main fastener (10), comprising a front side (101), a rear side (102), a left side (103), and a right side (104), wherein a clamp portion (1011) is formed at the front side (101) of the main fastener (10),
**characterized in that** the main fastener (10) further comprises a dovetail (1021) for interlocking a retaining member (40) of a communications equipment which is disposed at the rear side (102) of the main fastener (10);
wherein a first buckling portion (1031) is positioned at the left side (103) of the main fastener (10) and is interlocked with a second buckling portion at a right side of another main fastener; and/or a second buckling portion (1041) is positioned at the right side (104) of the main fastener (10) and is interlocked with a first buckling portion at a left side of another main fastener.

2. The main fastener (10) according to claim 1, wherein the first buckling portion (1031) is a male dovetail, the second buckling portion (1041) is a female dovetail groove; or the first buckling portion (1031) is a female dovetail groove, and the second buckling portion (1041) is a male dovetail.

3. The main fastener (10) according to claim 1, wherein holes (105) are opened extending through the front side (101) of the main fastener (10) and the rear side (102) of the main fastener (10).

4. A mounting component for mounting a communications equipment, comprising a buckling member and a steel strip, wherein
the buckling member and the steel strip are cooperatively fixed on a fixture;
the buckling member has a main fastener (10) according to claim 1.

5. The mounting component according to claim 4, wherein the buckling member is the main fastener (10), the front side (101) of the main fastener (10) has a through hole (108); the width of the through hole (108) matches with that of the steel strip, such that the steel strip is fixed on the main fastener (10) via the through hole (108).

6. The mounting component according to claim 5, wherein the dovetail (1021) at the front side (101) or the rear side (102) of the main fastener (10) is a female dovetail groove, the female dovetail groove is disposed with a blade spring (5013) at an upper edge, and the blade spring presses against a step-like structure of a male dovetail interlocked with the female dovetail groove.

7. The mounting component according to claim 4, wherein the first buckling portion (1031) is a male dovetail, the second buckling portion (1041) is a female dovetail groove; or the first buckling portion (1031) is a female dovetail groove, and the second buckling portion (1041) is a male dovetail.

8. The mounting component according to claim 5, wherein holes (105) are opened extending through the front side (101) of the main fastener (10) and the rear side (102) of the main fastener (10).

## Patentansprüche

1. Hauptbefestigungselement (10), umfassend eine Vorderseite (101), eine Rückseite (102), eine linke Seite (103) und eine rechte Seite (104), wobei ein Klemmteil (1011) an der Vorderseite (101) des Hauptbefestigungselements (10) ausgebildet ist, **dadurch gekennzeichnet, dass** das Hauptbefestigungselement (10) ferner einen Schwalbenschwanz (1021) zur Verriegelung eines Halteglieds (40) eines Kommunikationsgeräts umfasst, der auf der Rückseite (102) des Hauptbefestigungselements (10) angeordnet ist;
wobei ein erster Anbringteil (1031) auf der linken Seite (103) des Hauptbefestigungselements (10) positioniert ist und mit einem zweiten Anbringteil auf einer rechten Seite eines anderen Hauptbefestigungselements verriegelt ist und/oder ein zweiter Anbringteil (1041) auf der rechten Seite (104) des Hauptbefestigungselements (10) positioniert ist und mit einem ersten Anbringteil auf einer linken Seite eines anderen Hauptbefestigungselements verriegelt ist.

2. Hauptbefestigungselement (10) nach Anspruch 1, wobei der erste Anbringteil (1031) ein Schwalbenschwanzsteckteil ist, der zweite Anbringteil (1041) eine Schwalbenschwanzaufnahmenut ist oder der erste Anbringteil (1031) eine Schwalbenschwanzaufnahmenut ist und der zweite Anbringteil (1041) ein Schwalbenschwanzsteckteil ist.

3. Hauptbefestigungselement (10) nach Anspruch 1, wobei durch die Vorderseite (101) des Hauptbefestigungselements (10) und die Rückseite (102) des Hauptbefestigungselements (10) verlaufende Löcher (105) ausgebildet sind.

4. Montagebauteil zur Montage eines Kommunikationsgeräts, umfassend ein Knickglied und ein Stahlband, wobei
das Knickglied und das Stahlband zusammenwirkend auf einer Halterung befestigt sind;
das Knickglied ein Hauptbefestigungselement (10) nach Anspruch 1 hat.

5. Montagebauteil nach Anspruch 4, wobei das Knickglied das Hauptbefestigungselement (10) ist, die Vorderseite (101) des Hauptbefestigungselements (10) ein Durchgangsloch (108) hat, die Breite des Durchgangslochs (108) der des Stahlbands entspricht, so dass das Stahlband über das Durchgangsloch (108) an dem Hauptbefestigungselement (10) befestigt ist.

6. Montagebauteil nach Anspruch 5, wobei der Schwalbenschwanz (1021) an der Vorderseite (101) oder der Rückseite (102) des Hauptbefestigungselements (10) eine Schwalbenschwanzaufnahmenut ist, die Schwalbenschwanzaufnahmenut mit einer Blattfeder (5013) an einem oberen Rand angeordnet ist und die Blattfeder gegen eine absatzförmige Struktur eines mit der Schwalbenschwanzaufnahmenut verriegelten Schwalbenschwanzsteckteils drückt.

7. Montagebauteil nach Anspruch 4, wobei der erste Anbringteil (1031) ein Schwalbenschwanzsteckteil ist, der zweite Anbringteil (1041) eine Schwalbenschwanzaufnahmenut ist oder der erste Anbringteil (1031) eine Schwalbenschwanzaufnahmenut ist und der zweite Anbringteil (1041) ein Schwalbenschwanzsteckteil ist.

8. Montagebauteil nach Anspruch 5, wobei durch die Vorderseite (101) des Hauptbefestigungselements (10) und die Rückseite (102) des Hauptbefestigungselements (10) verlaufende Löcher (105) ausgebildet sind.

## Revendications

1. Élément de fixation principal (10), comprenant un côté avant (101), un côté arrière (102), un côté gauche (103) et un côté droit (104), une partie de serrage (1011) étant formée au niveau du côté avant (101) de l'élément de fixation principal (10), **caractérisé en ce que** l'élément de fixation principal (10) comprend en outre une queue d'aronde (1021) pour le verrouillage réciproque avec un élément de retenue (40) d'un équipement de communication qui est disposé au niveau du côté arrière (102) de l'élément de fixation principal (10) ;
une première partie d'attache (1031) étant positionnée au niveau du côté gauche (103) de l'élément de fixation principal (10) et étant verrouillée réciproquement avec une deuxième partie d'attache au niveau d'un côté droit d'un autre élément de fixation principal ; et/ou une deuxième partie d'attache (1041) étant positionnée au niveau du côté droit (104) de l'élément de fixation principal (10) et étant verrouillée réciproquement avec une première partie d'attache au niveau d'un côté gauche d'un autre élément de fixation principal.

2. Élément de fixation principal (10) selon la revendication 1, dans lequel la première partie d'attache (1031) est une queue d'aronde mâle, la deuxième partie d'attache (1041) est une rainure de queue d'aronde femelle ; ou la première partie d'attache (1031) est une rainure de queue d'aronde femelle et la deuxième partie d'attache (1041) est une queue d'aronde mâle.

3. Élément de fixation principal (10) selon la revendication 1, dans lequel des trous (105) sont ouverts de manière à s'étendre à travers le côté avant (101) de l'élément de fixation principal (10) et le côté arrière (102) de l'élément de fixation principal (10).

4. Élément de montage pour le montage d'un équipement de communication, comprenant un organe d'attache et une bande d'acier, dans lequel
l'organe d'attache et la bande d'acier sont fixés de manière coopérative sur une pièce fixe ;
l'organe d'attache a un élément de fixation principal (10) selon la revendication 1.

5. Élément de montage selon la revendication 4, dans lequel l'organe d'attache est l'élément de fixation principal (10), le côté avant (101) de l'élément de fixation principal (10) a un trou traversant (108) ; la largeur du trou traversant (108) correspond à celle de la bande d'acier, de telle sorte que la bande d'acier soit fixée sur l'élément de fixation principal (10) via le trou traversant (108).

6. Élément de montage selon la revendication 5, dans lequel la queue d'aronde (1021) au niveau du côté avant (101) ou du côté arrière (102) de l'élément de fixation principal (10) est une rainure de queue d'aronde femelle, la rainure de queue d'aronde femelle est disposée avec un ressort à lame (5013) au niveau d'un bord supérieur, et le ressort à lame presse contre une structure de type gradin d'une queue d'aronde mâle verrouillée réciproquement avec la rainure de queue d'aronde femelle.

7. Élément de montage selon la revendication 4, dans lequel la première partie d'attache (1031) est une queue d'aronde mâle, la deuxième partie d'attache (1041) est une rainure de queue d'aronde femelle ; ou la première partie d'attache (1031) est une rainure de queue d'aronde femelle et la deuxième partie d'attache (1041) est une queue d'aronde mâle.

8. Élément de montage selon la revendication 5, dans lequel des trous (105) sont ouverts de manière à s'étendre à travers le côté avant (101) de l'élément de fixation principal (10) et le côté arrière (102) de l'élément de fixation principal (10).
